# EUROPEAN PATENT SPECIFICATION

(11) **EP 4 062 181 B1**
(45) Date of publication and mention of the grant of the patent: **10.01.2024**
(21) Application number: 20820045.1
(22) Date of filing: 19.11.2020
(51) Int. Cl.: G01R 27/02, G01R 31/52, G01R 31/08

(54) **METHOD AND SYSTEM FOR CABLE INSULATION TESTING**
VERFAHREN UND SYSTEM ZUR KABELISOLATIONSPRÜFUNG
PROCÉDÉ ET SYSTÈME DE TEST D'ISOLATION DE CÂBLE

(30) Priority: 19.11.2019 GB 201916836
(43) Date of publication of application: 28.09.2022
(73) Proprietor: Viper Innovations Ltd, Portishead Bristol BS20 7AW (GB)
(72) Inventor: XU, Guangqiao, Bristol BS20 7AW (GB); OVERTON, Paul, Robert, Bristol BS20 7AW (GB); COVENTRY, Keith David, Bristol BS20 7AW (GB); SIMPSON, Steven Lewis Charles, Bristol BS20 7AW (GB)
(74) Representative: Marks & Clerk LLP
(86) International application number: PCT/EP2020/082739
(87) International publication number: WO 2021/099495

(56) References cited:
- EP-A2- 0 593 007
- CN-A- 110 208 662
- DE-A1-102011 050 590
- US-A- 5 691 644

## Description

### Field of Invention

The invention relates to insulation parameter testing, more particularly, though not exclusively, measuring the insulation resistance of a cable in a live system.

### Introduction

Insulation resistance of cables is measured to monitor the current leakage through insulation material surrounding a conductor. Typically, the insulation material is cable sheathing surrounding a conductor. Insulation resistance is tested/monitored because deterioration of insulation will cause current leakage to increase and can result in an electrical fault. Insulation resistance testing is commonly undertaken for cables used in applications such as subsea power transmission and railway signalling power transmission.

An unearthed, Isole Terre (IT) power distribution architecture is commonly used for mission-critical applications which require continuous service. Such applications may include subsea control networks, hospital intensive care units, railway signalling power systems, and airport field lighting system to name but a few. The use of an IT earthing arrangement is advantageous as it allows the system to remain operational in a single insulation fault scenario. In contrast, an earthed system, e.g. a Terre Neutral (TN) system, an insulation fault usually corresponds to a short circuit fault that causes a protection device to trip, resulting in a shutdown of part or all of the electrical system and loss of power to equipment and infrastructure.

While an IT system largely increases the availability of an electrical installation, it can be problematic to manage fault conditions and being able to identify and locate an insulation fault quickly and reliably is a well-recognised problem with in the prior art. Further, there are well recognised issues with performing cable insulation tests without de-energising the system which makes testing of mission-critical systems problematic.

Typical maintenance protocols require a scheduled system power-down with a significant amount of resource on the ground to do the periodic offline cable testing. This is clearly far from ideal and typically causes significant levels of disruption and cost for system owners and users. There are also safety risks associated with such testing. For example, injury can occur when live electrical parts at dangerous voltage are exposed and can be touched by humans, or, when components that are supposed to be earthed become live. Further, it is not uncommon for new faults to be introduced during the power up after a shut-down, especially in large power distribution networks with lots of installations.

The current industry common practice for measuring insulating resistance uses a DC voltage source for cable insulation testing and it can only be done when the cable is; i) not powered, and ii) physically disconnected from the system in which it is operating.

The present invention is aimed at addressing deficiencies of existing cable insulation testing methods/systems. CN110208662A discloses a mass spectrographic hyperconductive cable Polypropylene Laminated Paper (PPLP) insulation detecting method and system. DE102011050590A1 discloses insulation monitoring using a test signal of variable frequency. EP0593007A2 discloses a method of determining electric leakage in unearthed electric networks. US5691644A discloses neutral corrosion condition survey-mitigating induced voltage effects.

### Summary

The present invention provides a method for determining the state of a cable insulation parameter of a cable in an electrical system and a system for determining the state of a cable insulation parameter of an electrical system according to the appended claims.

A first aspect of this disclosure provides a method for determining the state of a cable insulation parameter of a cable in an electrical system according to claim 1.

The method provides an accurate estimate of the cable insulation parameter, which may be utilised in a live system (that is, an operational system). Individual cable insulation conditions can be monitored on a regular basis so that proactive measures can be taken rather than reactive measures. In the case of an insulation fault, this allows the fault to be quickly located without deploying a large amount of resources on the ground. In addition, this eliminates the need to have periodic cable testing, thereby avoiding unnecessary power-down of the system. This in turn brings a significant value to the asset management team of IT power distribution systems through a significant reduction in maintenance costs.

These advantages may be realised because the method enables an accurate estimation of insulation resistance using AC signals (rather than DC). Use of AC current to measure insulation resistance is conventionally difficult due to dielectric absorption - a concept that will be discussed in more detail below. The method enables use of AC current for measuring insulation parameters by accounting for the effect of dielectric absorption.

Optionally, providing of the alternating current signals is carried out whilst the conductor is either operational or not operational.

Optionally, the electrical system is an ungrounded electrical system.

Optionally, measuring the frequency response is carried out using a current transformer. Optionally, the injected signal is between the minimum coupling frequency and saturation frequency corresponding to the electromagnetic permeability of the current transformer. Optionally, the plurality of frequencies is between 0.1 Hz and 10Hz.

Optionally, the steps of providing and measuring are undertaken simultaneously.

Optionally, the injected signal and measured frequency response are digitally sampled. Optionally, the plurality of current signals is at least three predefined alternating current signals of different frequencies.

Optionally, the cable comprises at least two conductors, and wherein the steps of providing, measuring, determining, and extrapolating are undertaken in respect of one or more of the conductors.

Optionally, the electrical ground is earth.

Optionally, the cable resistive leakage current is determined at a plurality of test locations distributed along the cable, the resistive leakage current at each of the plurality of test locations being the total resistive leakage current downstream of the respective measurement point.

Optionally, the step of determining a first parameter at a first test location of the cable and a second parameter at a second test location of the cable that is downstream of the first test location, wherein the parameter of the cable in-between the first and second test locations is determined by subtracting the second parameter from the first parameter.

Optionally, the cable is a signalling cable for transmitting signals between components of a railway signalling system.

According to a second aspect of the disclosure there is provided a system for determining the state of a cable insulation parameter of an electrical system according to claim 12.

Optionally, the sensor arrangement further comprises at least one current transformer.

Optionally, the system further comprises an analogue-to-digital converter configured to digitally sample the plurality of alternating current signals and the corresponding measured frequency response for each of the plurality of alternating current signals.

Optionally, the cable comprises at least two conductors, and, the system is configured to determine insulation parameter for each of the conductors.

Optionally, the electrical ground is earth.

Optionally, the system comprises a plurality of measurement points located along the cable, each test location configured to determine the total insulation parameter downstream of the respective test location.

Optionally, the system is configured to determine a first insulation parameter at a first test location and a second insulation at a second test location that is downstream to the first test location, and further determine a sector insulation parameter of the cable in-between the first and second test locations by subtracting the first insulation parameter from the second insulation parameter.

Optionally, the system is a railway signalling system, and the cable is configured to transmit signals between components of the railway signalling system.

Optionally, the system further comprises an isolation transformer for isolating the electrical system from ground.

Optionally, the system further comprises a signal generator, which is configured to provide the AC voltage source and plurality of alternating current signals.

Optionally, the signal generator is configured to provide a spread spectrum signal comprising the plurality of alternating current signals.

Optionally, the signal processor is configured to demodulate the received measured frequency responses.

Optionally, the signal processor is located remote from the AC voltage source.

The skilled person will appreciate that except where mutually exclusive, a feature described in relation to any one of the aspects, examples or embodiments described herein may be applied to any other aspect, example, embodiment or feature.

### Brief description of drawings

Figure 1 is an equivalent circuit topology showing the electrical components constituting a cable, including those contributing to leakage currents.
Figure 2 is a plot showing a resistance-capacitance phasor measurement of current across the circuit topology of Figure 1.
Figure 3 is a diagrammatic representation of a system used for a testing method according to this disclosure.
Figure 4 is a circuit topology of a system used for a testing method according to this disclosure.
Figure 5 is a process flow diagram indicating an example method according to this disclosure.
Figure 6 is a plot showing phase measurements of readings for leakage current obtained using the system of Figure 3.

### Detailed description

Aspects of this disclosure enable measurement of insulation resistance using AC current, in particular, the resistance of insulation separating a conductor and earth. The insulation resistance corresponds to the current that "leaks" across such insulation. This current is referred to as "leakage current". By 'live' system, it will be appreciated that the system is capable of operating whilst the tests to determine an insulation parameter are being carried out. Thus, the system may not be isolated from a supply.

It is difficult to accurately measure insulation resistance using AC signals due to dielectric absorption. This is because voltage applied between a conductor and earth causes an electric field to be applied to the dielectric between the conductor and earth. This field exerts a torque on molecular dipoles within the dielectric, causing the directions of the dipole moments to align with the field direction. This change in molecular dipoles is called oriented polarization and also causes heat to be generated, resulting in dielectric losses (dissipation factor). The orientation of the dipoles does not follow the electric field synchronously, but is delayed by a time constant that depends on the material of the dielectric. This delay corresponds to a hysteresis response of the polarization to the external field.

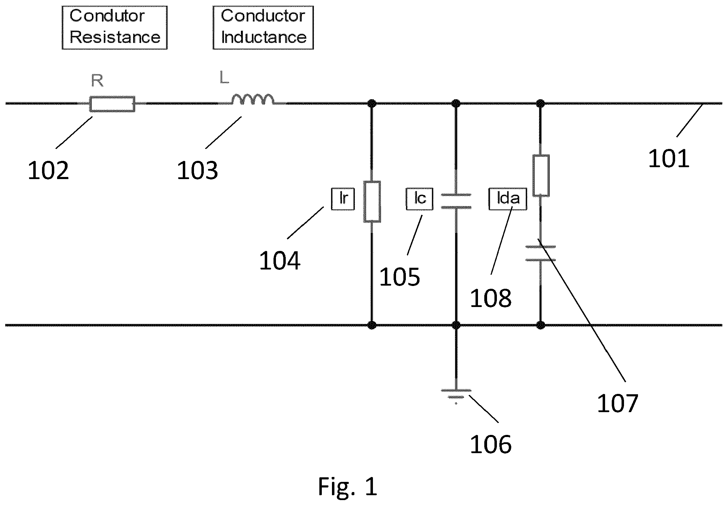

The electrical effect of dielectric absorption is shown in Figure 1 represented by a resistance and capacitance in series giving rise to a leakage current I_{da} 108. A conductor 101 is represented by a resistance 102 and inductance 103. Iᵣ 104 and I_{c} 105 are the resistive leakage current and capacitive leakage current respectively between the conductor 101 and ground 106. The dielectric absorption current caused by polarisation, as described above, is represented by I_{da}, 108.

In other words, the leakage current across the insulator includes a resistive leakage current 104, a capacitive leakage current 105, and an additional "dielectric absorption" current 108. Methods of this disclosure enable the resistive leakage current 104 to be determined, thereby enabling determination of the cable insulation resistance.

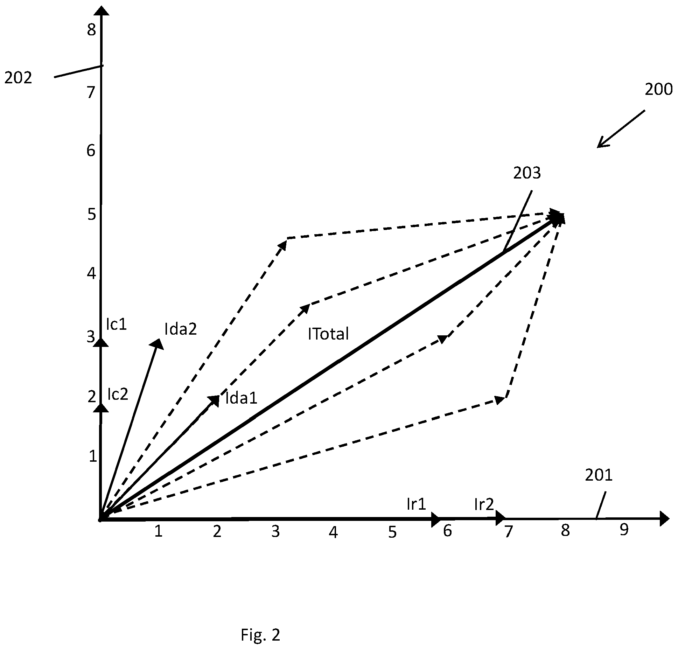

The existence of the I_{da} component makes it impossible to derive the value of resistive leakage current Iᵣ via phase demodulation (e.g. using a phasor diagram). This is because for any given leakage current amplitude and phase shift, there will be an indefinite number of combinations across these components due to dielectric absorption. This is illustrated with reference to Figure 2.

Plot 200 of Figure 2 is a resistance-capacitance phasor diagram. Purely resistive current is indicated on the x-axis 201 and purely capacitive current is indicated on the y-axis 202. A phase shift arising from the components 104, 105, 108 of Figure 1, obtained using a particular AC current frequency, is indicated using phasor vector 203. The vector 203 has a magnitude and phase angle corresponding to the total resistive (Iᵣ), capacitive (I_{c}), and dielectric absorption (I_{da}) currents. Phasor vector 203 includes both resistive and capacitive components. Therefore, if I_{da} is not known, it is impossible to extract the correct readings for Iᵣ or I_{c} from the "combined" vector 203. For example, reading the resistive current component from the phasor vector 203 provides a value (on x-axis 201) that includes the resistive component of I_{da}, which is unknown.

In the particular example shown in Figure 2, the vector 203 comprises two groups of leakage current values (e.g. Iᵣ₁, Iᵣ₂) which correspond to the leakage current for multiple portions of a conductor downstream from the location of the conductor where the measurement was taken for obtaining vector 203.

In addition, the characteristics of dielectric absorption current I_{da} varies significantly with the polarisation level at the time of each measurement, which is susceptible to many external factors. This is why the industry common practice method of insulation resistance testing uses DC current instead, since there is no capacitive effect and the measured current purely resistive. Measuring leakage current using DC current provides the correct Iᵣ value without requiring consideration of dielectric absorption current. Use of DC current is disadvantageous for the reasons discussed above - particularly, since it requires the system to be shut down.

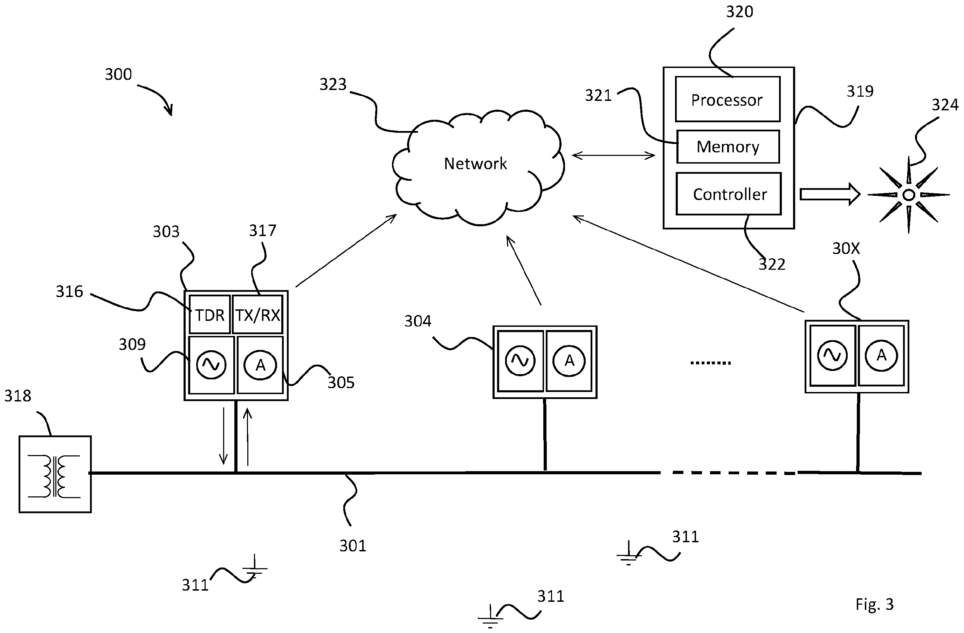

An advantageous method and system for testing the insulation resistance of a cable section is now described with reference to Figure 3.

Figure 3 shows an electrical installation (which may also be referred to as an electrical system) 300 comprising a plurality of test units 303, 304, 30X, provided at test locations which are distributed along a cable 301 which is to be tested. The test units 303, 304 may be dedicated units, which are provided solely for the purpose of testing the cable 301 along which they are installed, or, alternatively, they may be combined with other equipment which may include power distribution equipment, communication equipment and/or control equipment, for example. The electrical installation 300 may form part of an electrical network which is part of a railway signalling power system (for example) but may be utilised in any suitable electrical network or distribution system. Examples of relevant electrical systems may include subsea electrical networks, in particular control networks, hospital intensive care units and airport field lighting systems to name but a few. In the case of a railway signalling system, the test units 303, 304, 30X may be distributed along a section of railway line and be permanently or temporarily installed. The test units 303, 304, 30X may form part of the signalling control network that already exists. However, it will be appreciated that this is not a limitation of the invention and the system may be installed as and where required.

The cable 301 may be a conventional cable, which includes at least one line which is sheathed by an insulating material. The electrical system to which the invention is applied may be ungrounded, as noted above in the background section, but this is not a limitation and the methods described herein may be applied to grounded systems. It will be appreciated that the electrical installation 300, although not actively provided with a ground connection, may be surrounded by electrical infrastructure or objects which provide a ground connection 311 against which an insulation fault can be measured. The ground connection 311 may be provided by an outer sheathing or screen of the cable, for example, or by a cable carrying member such as a cable tray, trunking or conduit. Alternatively or additionally, the ground connection may be provided by the surrounding earth. These ground connections 311 are electrically isolated from the line of the cable in normal operation by virtue of using an isolating transformer 318 for the supply, thereby making the system an IT system, as known in the art.

Each test unit 303 - 30X may comprise a voltage source in the form of a signal generator 309 and a sensor arrangement 305. The signal generator 309 may be any electrical or electronic device which can provide a required alternating current, AC, voltage source with which to test the line in question. The signal generator 309 may be a function generator, direct digital synthesiser, an arbitrary waveform generator or digital pattern generator, to name but a few possible devices. The signal generator 309 may be configured or controlled to provide a test signal between ground and the line to be tested. The test signal may comprise a plurality of different test frequencies.

The different frequencies may be provided as temporally spaced discrete frequencies or as part of a sweep. Alternatively, the frequencies may be provided as part of a spread spectrum signal, as is well known in the art.

The plurality of frequencies may be a range defined by a lower limit and an upper limit. The lower limit may be any value which is capable of being detected by the sensor arrangement 305 according to the present disclosure. The upper limit may be application specific and determined on the basis of the property which is being interrogated. Thus, for an assessment of the insulation resistance, the frequency may be relatively low. For example, the upper frequency may be below 50Hz, or below 25Hz, or below 10Hz. In some examples, the upper frequency may be as low as 5Hz.

In other examples, the property to be assessed in the cable may be the insulation capacitance. The frequencies applied to the line to determine the insulation capacitance will be relatively high when compared to those for the insulation resistance testing. The lower limit may be between 100Hz and 10kHz, for example.

It will be appreciated that the frequency range may be configured to provided data which may be used for determining the insulation resistance and insulation capacitance. Hence, for example, the signal generator may be swept from 0.01 Hz (or any of the other IR frequencies) to 10kHz (or any other frequency which is applicable to the insulation capacitive test).

The lower limit of the frequency band may be any non-zero (that is, non-DC) frequency. In some examples, the frequency lower limit may be 0.01 Hz, or 0.1 Hz or 1 Hz, but other frequencies are possible and the values provided here for the lower and higher limits should not be seen as limiting.

As noted above, it will be appreciated that the frequency of the voltage source may be limited by the sensing capabilities of the sensor arrangement 305. Thus, in the case where the sensing arrangement comprises one or more current transformers, the frequency range may be determined by a minimum coupling frequency and saturation frequency corresponding to the electromagnetic permeability of the material used in the core of the current transformer.

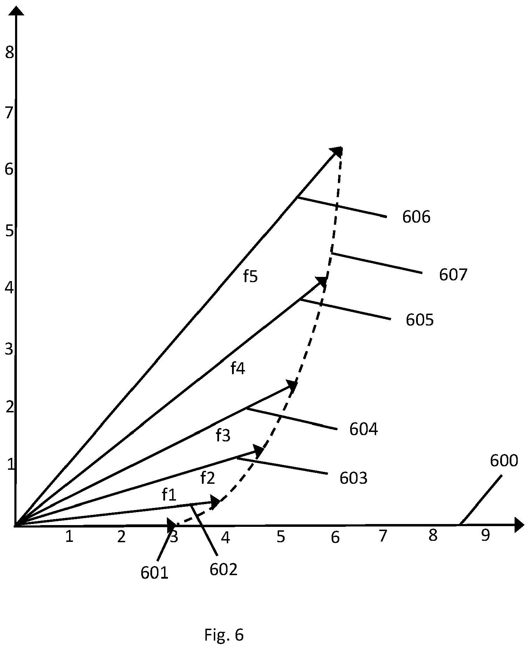

As will be discussed in more detail below (in relation to Figure 6),the use of a plurality of frequencies allows the frequency response of the cables to be assessed. This may be used to extrapolate the frequency responses to determine a DC response of the cable and an associated insulation resistance, for example. As such, the number of different frequencies provided between the upper and lower limits may be determined by the accuracy of the results required of the extrapolation. In other examples, the number of frequencies may be restricted by a time constraint which implements a window in which the testing can be carried out. In other examples, there may be a resource constraint (in terms of the signal generator capabilities for example).

In one example, there may be just three frequencies which may be a minimum for an extrapolation of the data points to provide the information necessary to determine the insulation parameter. In other examples, there may be five, eight, twenty, a hundred or more different frequencies within the frequency sweep carried out by the signal generator/voltage source.

With continued reference to Figure 3, the sensor arrangement 305 may include one or more sensors located on or adjacent to the line which is to be tested. The sensors may be a current transformer which is arranged in relation to the line to allow the current flowing within the line to be sensed. The cable 301 may include a line in and a line out such that the test unit 303 is either placed in series with the cable 301 or the sensors 305 of the test unit 303 are collocated with the signal generator 309 within a common housing together with any other necessary equipment. In other examples, the test unit 303 may comprise one or more leads which extend between the test unit 303 and the cable 301 such that the sensors 305 may be located remotely from the signal generator 309. In other examples, the sensors 305 may be wirelessly connected to the test unit 303. In further examples, the sensors 305 may be located at a separate location to the signal generator 309 such that the test unit 303 may be considered to be distributed. Thus, a distributed test unit may be considered to comprise a signal generator 309 and a sensor arrangement 305, whether these are collocated or otherwise.

The current transformers may be common mode current transformers. It will be apparent that other current sensing technologies may be used to implement the method of the present disclosure.

The cable 301 may comprise a transformer arrangement 318 which may be provided at one end of the cable and provide isolation of the electrical system from ground 311.

As noted above, the test units 303-30X may be provided at test locations along a cable 301 to be tested. The plurality of test units 303-30X may include a first test unit 303 at a first test location. There may be a second test unit 304 at a second test location. The test units 303, 304 may extend from the first test unit 303 to an N-th test unit 30X, where N is an integer. The number of test units will be application specific and may be determined by the electrical system which is being investigated.

Each test unit 303-30X may operate independently from each of the other and provide a measurement relating to a parameter of the line to be tested. Providing test units 303-30X at multiple test locations may advantageously allow the system 300 to obtain a local measurement for an insulation parameter. This may be preferable where the voltage which can be applied to the line is limited. That is, the lower the voltage of the test waveform, the lower the range of the test. Thus, providing a plurality of test units may help to provide more accurate results and allow the test voltage to be reduced. Further, the test measurements from a plurality of test locations may advantageously be used to determine an approximate location of a fault. This is described further below.

The test units 303-30X may be directional. Hence, the test units may be configured to determine a parameter of the cable 301 in a downstream or an upstream location. Thus, in one example, the test units 303-30X may obtain a value of insulation resistance for a stretch of cable which is downstream of the test unit 303-30X. The definition of downstream and upstream may be in relation to the supply 318 and load, in which the supply is upstream and the load is downstream.

The measurements taken at each of the test units 303-30X may be used individually or in combination. When used in combination, it may be possible to determine which section of the cable 301 has a cable parameter which is below a predetermined threshold or range which is indicative of a fault or a potential fault condition. This may be achieved by obtaining a first parameter measurement from a first test location, and subtracting it from a second parameter measurement from a second test location. The first parameter measurement may be taken downstream of the second parameter measurement. By subtracting the two parameter measurements, it may be possible to determine what the parameter measurement is for the length of cable which extends between the first and second parameter measurement locations. It will be appreciated that reference to the first and second parameter measurements and test locations is arbitrary and these may be interchangeable. Thus, the second parameter measurement may be downstream of and subtracted from the first parameter measurement.

Where a coarse location has been provided, for example, by using the subtractive method described immediately above (and in further detail below), it may be possible and advantageous to find a precise location of the fault using known techniques. In order to achieve this, one or more of the test units 303-30X may include a fault location module 316. The fault location module 316 may be used to determine the precise location of a fault within a segment of the cable run. For example, the fault location module 316 may be used to determine the location of a fault between two of the test locations or test units 303-30X. The fault location module 316 may comprise a time domain reflectometry module, in particular, a spread spectrum time domain reflectometry module. The time domain reflectometry and spread spectrum time domain reflectometry may be carried out in accordance with techniques known in the art. Other fault location schemes may be employed within the present disclosure, include other types of time domain reflectometry or other methods.

Each of the test units 303-30X may include signal processing equipment which may receive the test measurement signals from the sensor arrangement 305. The test measurement signals may be a frequency response of the line 301 resulting from the test signal being placed on the line 301. The signal processing equipment may be used to determine one or more parameters of the line 301 being tested. The parameter may be, for example, the insulation resistance or insulation capacitance from a live cable 301. More particularly, the signal processing equipment may determine a phase difference between the voltage source and the test measurement signals. The phase difference may be determined for a plurality of frequency responses, each frequency response corresponding to a different frequency of test signal. The signal processing equipment may additionally determine a resistance value for the plurality of frequency responses. The determination of the resistance value may be determined from the plurality of phase differences determined from the plurality of frequency responses.

In one example, the plurality of phase differences may be extrapolated to determine a DC response of the cable. Thus, the extrapolation may provide a leakage current which is equivalent to the leakage current that would flow if the injected test current was a DC current. This can be considered to be a DC insulation resistance value.

The extrapolation may be carried out using any suitable known technique. In one example, the extrapolation may be achieved by Nth order polynomial regression or equivalent techniques.

In other examples, the plurality of phase differences may be extrapolated to determine the insulation capacitance. This may be achieved by extrapolating the plurality of frequency responses to a point which is sufficiently asymptotic such that the capacitive component of frequency response may be determined. For example, with reference to Figure 1, as the frequency is increased, the capacitance I_{c} 105 and capacitance component of I_{da} 107 will eventually become a short circuit. This means that current leakage through the resistance components of Iᵣ 104 and I_{da} 108 would be negligible in comparison with the current leakage through I_{c} 105. Therefore, the resulting phase angle (not shown) on a phasor diagram would be extremely close to 90 degrees (i.e. to the y-axis 202 in Figure 2) and therefore the capacitance component I_{c} 105 of the insulation resistance can be determined. There may of course be other ways in which the insulation capacitance may be determined from the plurality of frequency responses.

The signal processing may be carried out locally or remotely. When the signal processing is carried out locally (not shown), one of the test units will be configured as a master unit for collecting and processing data on a locally hosted server via local communication protocols.

Figure 3 shows an example where the signal processing is carried out remotely. With reference to Figure 3, each of the test units 303-30X may include a transmitter 317 to transmit test measurement data relating to the test measurement signal measured by the sensor arrangement 305. The transmitter 317 may transmit the test measurement data to remote signal processing equipment 319 which is configured to carry out one or more of the aspects of the signal processing as described herein.

The transmission may be performed using one or more wired and/or wireless networks 323 using one or more known communication protocols (e.g. IEEE802.3 or 802.11 variations, WiFi (RTM), Bluetooth (RTM), TCP/IP, Ethernet, etc). The transmission network may be a public communications network such as the internet or a mobile data network (e.g. 4G/5G). Alternatively or additionally, the transmission network may include a private communications network comprising a local or wide area network. The signal processing equipment may be carried out by a remote server. The remote server may be cloud based. The signal processing equipment may comprise at least one processor 320 and at least one memory 321. The memory 321 may be configured to store a computer program comprising computer readable instructions that, when read by the at least one processor 320, causes performance of the methods described herein. The computer program may be software or firmware, or may be a combination of software and firmware.

The signal processing equipment 319 may comprise a controller 322. The controller 320 may comprise: control circuitry; and/or processor circuitry; and/or at least one application specific integrated circuit (ASIC); and/or at least one field programmable gate array (FPGA); and/or single or multi-processor architectures; and/or sequential/parallel architectures; and/or at least one programmable logic controllers (PLCs); and/or at least one microprocessor; and/or at least one microcontroller; and/or a central processing unit (CPU); and/or a graphics processing unit (GPU), to perform the methods. The controller 322 may be configured to control the scheduling of test measurements by the test units 303-30X and coordinate receiving of the test measurement data after a test has been performed.

The controller 322 may also be configured to communicate with an external entity to receive a required test schedule or test request, and may also be configured to communicate the results of a test measurement in the form of test measurement data or to provide an advisory indication which results from the test measurement data. A communication 324 of the test measurement data may be transmitted/provided by the signal processing equipment 319 to other equipment (not shown) and comprise: one or more packets of data, a test result such as a "pass", "fail", "requires further investigation" and/or one or more visual or audible visual indicators which are indicative of the state of the cable as a result of the test. The test result may be specific to a section of line, for example, a section of line between two of the test units, in which case, the test measurement may also comprise a location or identifier which is representative of a location.

The testing of the cable 301 may be carried out on a predetermined schedule. The testing may be carried out once per year for example, or once per week, or once per day, for example. The tests may be prompted by an event such as an extreme weather event or in response to a determination that there may be a fault on the line or some other cue.

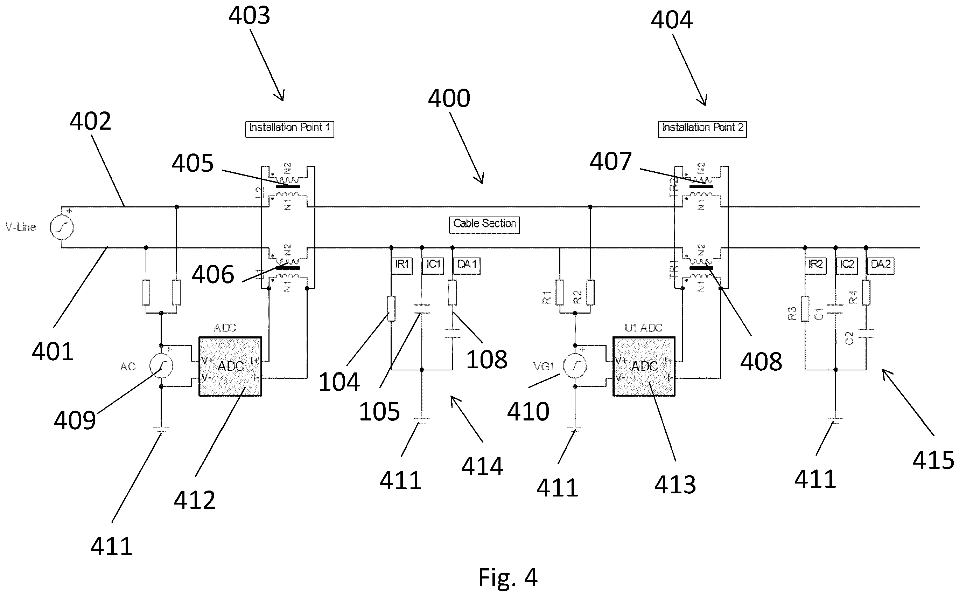

Figure 4 shows a section of cable with test units according to an embodiment of the present disclosure. Thus there is shown, a cable section 400 which is operational and thus includes live conductors 401 and 402. The particular example shown includes two live conductors however, there could be any number of conductors in a cable section and, in some examples, the cable may not be operational and may be dead, that is, isolated from an operational electrical supply. An aim of the test is to obtain a cable section insulation resistance 104 between the two test locations 403 and 404 at which there are located test units which may be similar to those described above.

At each test location 403, 404 there is test signal generator in the form of an AC voltage source 409, 410, configured to apply a signal between the conductors 401, 402 and earth 411 and a sensing arrangement which may comprise at least one current transformer. The at least one current transformers may be located on the line at a downstream or upstream location of the voltage source. As shown in Figure 4, they are located downstream of the voltage source, thereby allowing the measurement of insulation resistance to be relevant to the downstream section of cable. The directionality of the measurement of the insulation resistance from the voltage source is configurable based on whether the at least one current transformers are located upstream or downstream (or both) of the voltage source.

Each line may comprise a current transformer and the current transformers may be connected in parallel such that a combined measurement to ground can be taken for each of the lines simultaneously. Thus, the current transformers may be referred to as common mode current transformers. This may be advantageous when the lines are connected via a transformer, as per the system shown in Figure 3. However, this is not a limitation, and each line may be tested separately.

In order to provide an accurate determination of the phase difference between the injected signal provided by the signal generator and the measurement signal, each signal may be sampled. Thus, each test location may comprise an analogue-to-digital converter 412, 413 which is configured to measure/sample both i) the voltage of signals provided by the AC voltage sources 409, 410, and, ii) the corresponding current from the conductors 401, 402 via transformers 405, 406, 407, 408 at each test location 403, 404.

The various measured leakage currents in the system are schematically represented by IR1, IC1, DA1, IR2, IC2, DA2 in circuits 414, 415. As noted above, the test signal may be carried out at different frequencies which will each provide a corresponding value of the currents IR, IC and DA, in which IR is the current contribution from insulation resistance, IC is the current contribution from the insulation capacitance, and DA is the leakage current contribution from the dielectric absorption.

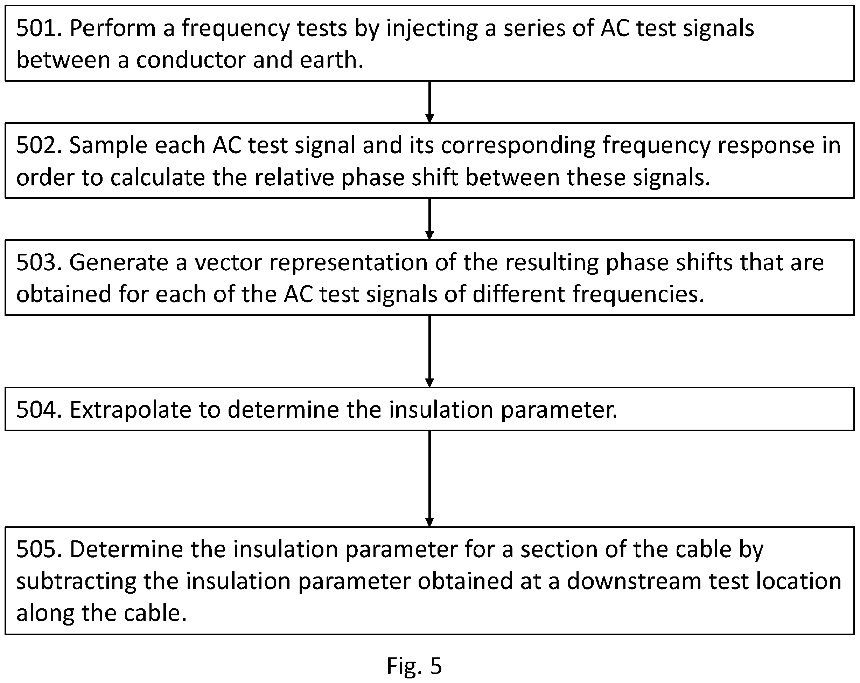

According to a method of this disclosure, and with reference to Figure 4 and Figure 5, the following steps are undertaken:
Perform a plurality of frequency tests 501 by providing a series of AC test signals using the AC voltage source 409, 410 between the conductors 401, 402, and ground 411. Each AC test signal has a different known frequency and amplitude. The plurality of frequency tests can be injected whilst a functional AC or DC current is being transmitted through the conductors 401, 402. If the functional current is AC, then the sweep test signals have a different frequency to the functional AC current. Further, the plurality of frequencies may be injected simultaneously using a suitably modulated signal. The suitable test signal which comprises the different signals may be a spread spectrum frequency signal in which the different frequencies are provided by different portions of a relatively wide bandwidth signal, as known in the art.

The measurement of the frequency response from each test signal may be carried out simultaneously. Hence, each injected AC test signal and its corresponding frequency response may be sampled 502 in order to calculate the relative phase shift between these signals. The sampling is undertaken by a converter 412, 413 for each test location. The frequency response is obtained via the current transformers 405, 406, 407, 408. In the example shown in Figure 4, the converters measure voltage that is injected by the AC voltage source 409 and the current response via current transformers 405, 406, 407, 408. In this example, the converters 412, 413 are analogue-to-digital converters for converting analogue measurements to digital samples for processing.

The next step may be to generate a vector representation 503 of the resulting phase shifts that are obtained for each of the AC test signals of different frequencies. An example of this representation is shown in Figure 6. Each vector line 602, 603, 604, 605, 606 represents a phase shift for a different injected AC signal having a unique frequency. A linear representation of the discrete test result points for each of the test measurements at the different frequencies may be provided by calculating a mathematical approximation. Thus, a curve 607 may be mathematically fitted o the endpoints of the vectors using one or more interpolation techniques or a mere linearization between any two adjacent points. The resultant curve connecting the end points of the phase shifts may be extrapolated (or otherwise solved) to determine the DC equivalent test result which is represented by the leakage current when the capacitive current Ic is zero. That is, the equation of the curve 607 may be solved to estimate the leakage current Ir 601 where the capacitive leakage current (represented on the Y-axis) is zero. In other words, the curve is extrapolated to estimate the resistive component of leakage current where the capacitor component of leakage current is zero.

Carrying out these steps means that the Ida component and Ic components may be eliminated and not included in the estimated value of Ir 601. With reference, to Figure 1, if capacitive current is removed, then the only remaining current value is Ir, the resistive leakage current. The resulting value for resistive leakage current may be referred to as the compensated reference directional resistive leakage current. This method step is typically undertaken by computing or other electrical equipment (not shown in Figure 4 but described above) configured to receive sampling measurements from the converters 412, 413.

The method steps above provide a value of resistive leakage current at a particular location of the cable corresponding to the test location 403, 404 that is used to take the measurements. With continued reference to Figure 4, installation point 1, 403, provides a compensated resistive current value that is equal to the sum of Ir1 and Ir2 being the total current leakage downstream of the location where the reading is taken. To obtain Ir1 in isolation (the insulation resistance at the cable section between the test locations 403, 404), the value of Ir2 may be estimated using test location 404 which can be subtracted from the leakage current estimated using test location 1, 403 (see method step 505). The final compensated cable section insulation resistance value is determined based on Ir1. That is, the test measurement provided by test location 1, comprises the leakage current of leakage components for the cable downstream of test location 1, and the test measurement provided by test location 2, comprises the leakage components for the cable downstream of test location 2.

It is found that the voltage drop due to the resistance of the cable itself (not shown) is normally negligible in comparison with the leakage impedance and can be ignored when undertaking method steps according to this disclosure. In other words, not considering the voltage drop due to the resistance of the cable itself has little impact on the measurement accuracy because the line resistance is negligible in comparison with the overall leakage impedance.

It will be understood that the invention is not limited to the examples and embodiments above-described and various modifications and improvements can be made.

## Claims

1. A method for determining the state of a cable insulation parameter of a cable (301) in an electrical system, the method comprising the steps of:
providing (501), by an AC voltage source (409), a plurality of alternating current signals between a conductor (401) of the cable and an electrical ground (411), wherein the plurality of alternating current signals comprise a plurality of frequencies, in which each alternating current signal comprises a different frequency greater than zero;
measuring (501) a frequency response for each of the plurality of alternating current signals;
determining (502) a plurality of phase shifts, each of the plurality of phase shifts being between each injected alternating current signal and the corresponding measured frequency response, **characterized by** : If
each of the phase shifts being represented as a phasor vector (203) having a magnitude and a phase angle and including a resistive component and a capacitive component, the method further comprising the step of:
extrapolating (504) the phasor vectors (203) to:
i) estimate the cable insulation parameter being an insulation resistance leakage current corresponding to the resistive component when the capacitive component is zero to provide a DC insulation resistance value, or
ii) estimate the cable insulation parameter being the insulation capacitance by extrapolating the plurality of phase shifts to a point that is asymptotic and determining the capacitive component at the asymptotic point.

2. The method according to any preceding claim, wherein providing the alternating current signals is carried out whilst the conductor (401) is operational.

3. The method according to any preceding claim, wherein the electrical system is an ungrounded electrical system.

4. The method of any preceding claim, wherein measuring the frequency response is carried out using a current transformer (318), and optionally wherein the injected signal is between the minimum coupling frequency and saturation frequency corresponding to the electromagnetic permeability of the current transformer (318).

5. The method of any preceding claim, wherein the steps of providing and measuring are undertaken simultaneously.

6. The method of any preceding claim, wherein the injected signal and measured frequency response are digitally sampled.

7. The method according to any preceding claim, wherein the plurality of current signals comprises at least three predefined alternating current signals of different frequencies.

8. The method of any preceding claim, wherein the cable comprises at least two conductors (401, 402), and wherein the steps of providing, measuring, determining, and extrapolating are undertaken in respect of one or more of the conductors (401, 402).

9. The method of any preceding claim, wherein the electrical ground is earth (411).

10. The method according to any preceding claim, wherein the insulation resistance leakage current is determined at a plurality of test locations distributed along the cable, the insulation resistance leakage current at each of the plurality of test locations being the total resistive leakage current downstream of the respective measurement point, and optionally further comprising the step of determining a first parameter at a first test location of the cable and a second parameter at a second test location of the cable that is downstream of the first test location (403), wherein the parameter of the cable in between the first and second test locations (403, 404) is determined by subtracting the second parameter from the first parameter.

11. The method according to any preceding claim, wherein the cable is a signalling cable for transmitting signals between components of a railway signalling system.

12. A system for determining the state of a cable insulation parameter of an electrical system, the system comprising:
an AC voltage source (409, 410) configured to provide a plurality of alternating current signals between a conductor (401) of the cable and an electrical ground (411), wherein the plurality of alternating current signals comprise a plurality of frequencies, in which each alternating current signal comprises a different frequency greater than zero;
a first sensor arrangement (305) configured to measure a frequency response for each of the plurality of alternating current signals; and
a signal processor configured to receive both the plurality of alternating current signals and corresponding measured frequency response, and, to determine a plurality of phase shifts for each current signal, **characterized by** :
each of the phase shifts being represented as a phasor vector (203) having a magnitude and a phase angle and including a resistive component and a capacitive component,
wherein the signal processor is further configured to extrapolate the phasor vectors (203) to:
i) estimate the cable insulation parameter being an insulation resistance leakage current corresponding to the resistive component when the capacitive component is zero to provide a DC insulation resistance value, or
ii) estimate the cable insulation parameter being the insulation capacitance by extrapolating the plurality of phase shifts to a point that is asymptotic and determining the capacitive component at the asymptotic point.

13. The system according to claim 12, further comprising a plurality of measurement points located along the cable, each test location configured to determine the total insulation resistance leakage current downstream of the respective test location, and the system optionally configured to determine a first insulation parameter at a first test location and a second insulation parameter at a second test location that is downstream to the first test location, and further determine a sector insulation parameter of the cable in-between the first and second test locations by subtracting the first insulation parameter from the second insulation parameter.

14. The system according to any of claims 12 or 13, further comprising an isolation transformer for isolating the electrical system from ground.

15. The system according to any of claims 12 to 14, wherein:
the system further comprises a signal generator (309) which is configured to provide the AC voltage source (409, 410) and plurality of alternating current signals, wherein the signal generator (309) is optionally configured to provide a spread spectrum signal comprising the plurality of alternating current signals, and wherein the signal processor is optionally further configured to demodulate the received measured frequency responses and/or
the signal processor is located remote from the AC voltage source (409, 410).

## Patentansprüche

1. Verfahren zum Bestimmen des Zustands eines Kabelisolationsparameters eines Kabels (301) in einem elektrischen System, wobei das Verfahren die folgenden Schritte umfasst:
Bereitstellen (501) einer Vielzahl von Wechselstromsignalen zwischen einem Leiter (401) des Kabels und einer elektrischen Masse (411) durch eine Wechselspannungsquelle (409), wobei die Vielzahl von Wechselstromsignalen eine Vielzahl von Frequenzen umfasst, bei denen jedes Wechselstromsignal eine unterschiedliche Frequenz größer als null umfasst,
Messen (501) eines Frequenzgangs für jedes der Vielzahl von Wechselstromsignalen;
Bestimmen (502) einer Vielzahl von Phasenverschiebungen, wobei jede der Vielzahl von Phasenverschiebungen zwischen jedem eingespeisten Wechselstromsignal und dem entsprechenden gemessenen Frequenzgang liegt, **dadurch gekennzeichnet, dass**:
jede der Phasenverschiebungen als ein Phasorvektor (203) dargestellt wird, der eine Größe und einen Phasenwinkel aufweist und eine Widerstandskomponente und eine Kapazitätskomponente einschließt, wobei das Verfahren ferner den folgenden Schritt umfasst:
Extrapolieren (504) der Phasorvektoren (203), um:
i) den Kabelisolationsparameter zu schätzen, der ein Isolationswiderstandsleckstrom ist, welcher der Widerstandskomponente entspricht, wenn die Kapazitätskomponente null ist, um einen Gleichstrom-Isolationswiderstandswert bereitzustellen, oder
ii) den Kabelisolationsparameter, bei dem es sich um die Isolationskapazität handelt, zu schätzen, indem die Vielzahl von Phasenverschiebungen bis zu einem asymptotischen Punkt extrapoliert wird und die kapazitive Komponente an dem asymptotischen Punkt bestimmt wird.

2. Verfahren nach einem der vorhergehenden Ansprüche, wobei das Bereitstellen der Wechselstromsignale vollzogen wird, während der Leiter (401) in Betrieb ist.

3. Verfahren nach einem der vorhergehenden Ansprüche, wobei das elektrische System ein ungeerdetes elektrisches System ist.

4. Verfahren nach einem der vorhergehenden Ansprüche, wobei das Messen des Frequenzgangs unter Verwendung eines Stromwandlers (318) vollzogen wird, und optional wobei das eingespeiste Signal zwischen der minimalen Kopplungsfrequenz und der Sättigungsfrequenz entsprechend der elektromagnetischen Permeabilität des Stromwandlers (318) liegt.

5. Verfahren nach einem der vorhergehenden Ansprüche, wobei die Schritte des Bereitstellens und des Messens gleichzeitig durchgeführt werden.

6. Verfahren nach einem der vorhergehenden Ansprüche, wobei das eingespeiste Signal und der gemessene Frequenzgang digital abgetastet werden.

7. Verfahren nach einem der vorhergehenden Ansprüche, wobei die Vielzahl von Stromsignalen mindestens drei vordefinierte Wechselstromsignale mit unterschiedlichen Frequenzen umfasst.

8. Verfahren nach einem der vorhergehenden Ansprüche, wobei das Kabel mindestens zwei Leiter (401, 402) umfasst, und wobei die Schritte des Bereitstellens, Messens, Bestimmens und Extrapolierens in Bezug auf einen oder mehrere der Leiter (401, 402) durchgeführt werden.

9. Verfahren nach einem der vorhergehenden Ansprüche, wobei die elektrische Masse die Erdung (411) ist.

10. Verfahren nach einem der vorhergehenden Ansprüche, wobei der Isolationswiderstandsleckstrom an einer Vielzahl von Prüfstellen bestimmt wird, die entlang des Kabels verteilt sind, wobei der Isolationswiderstandsleckstrom an jeder der Vielzahl von Prüfstellen der gesamte Widerstandsleckstrom im nachgelagerten Bereich des jeweiligen Messpunkts ist, und optional ferner umfassend den Schritt des Bestimmens eines ersten Parameters an einer ersten Prüfstelle des Kabels und eines zweiten Parameters an einer zweiten Prüfstelle des Kabels, die im nachgelagerten Bereich der ersten Prüfstelle (403) liegt, wobei der Parameter des Kabels zwischen der ersten und der zweiten Prüfstelle (403, 404) durch Subtrahieren des zweiten Parameters von dem ersten Parameter bestimmt wird.

11. Verfahren nach einem der vorhergehenden Ansprüche, wobei das Kabel ein Signalkabel zum Übertragen von Signalen zwischen Komponenten eines Eisenbahn-Signalsystems ist.

12. System zum Bestimmen des Zustands eines Kabelisolationsparameters eines elektrischen Systems, wobei das System Folgendes umfasst:
eine Wechselspannungsquelle (409, 410), die so konfiguriert ist, dass sie eine Vielzahl von Wechselstromsignalen zwischen einem Leiter (401) des Kabels und einer elektrischen Masse (411) bereitstellt, wobei die Vielzahl von Wechselstromsignalen eine Vielzahl von Frequenzen umfasst, bei denen jedes Wechselstromsignal eine unterschiedliche Frequenz größer als null umfasst,
eine erste Sensoranordnung (305), die konfiguriert ist, um einen Frequenzgang für jedes der Vielzahl von Wechselstromsignalen zu messen; und
einen Signalprozessor, der konfiguriert ist, um sowohl die Vielzahl von Wechselstromsignalen als auch einen entsprechenden gemessenen Frequenzgang zu empfangen und eine Vielzahl von Phasenverschiebungen für jedes Stromsignal zu bestimmen, **dadurch gekennzeichnet, dass**:
jede der Phasenverschiebungen als ein Phasorvektor (203) dargestellt wird, der eine Größe und einen Phasenwinkel aufweist und eine Widerstandskomponente und eine Kapazitiätskomponente einschließt,
wobei der Signalprozessor ferner konfiguriert ist, um die Phasorvektoren (203) zu extrapolieren, um:
i) den Kabelisolationsparameter zu schätzen, der ein Isolationswiderstandsleckstrom ist, welcher der Widerstandskomponente entspricht, wenn die Kapazitätskomponente null ist, um einen Gleichstrom-Isolationswiderstandswert bereitzustellen, oder
ii) den Kabelisolationsparameter, bei dem es sich um die Isolationskapazität handelt, zu schätzen, indem die Vielzahl von Phasenverschiebungen bis zu einem asymptotischen Punkt extrapoliert wird und die Kapazitätskomponente an dem asymptotischen Punkt bestimmt wird.

13. System nach Anspruch 12, ferner umfassend eine Vielzahl von Messpunkten, die sich entlang des Kabels befinden, wobei jede Prüfstelle so konfiguriert ist, dass sie den gesamten Isolationswiderstandsleckstrom im nachgelagerten Bereich der jeweiligen Prüfstelle bestimmt, und wobei das System optional so konfiguriert ist, dass es einen ersten Isolationsparameter an einer ersten Prüfstelle und einen zweiten Isolationsparameter an einer zweiten Prüfstelle bestimmt, die im nachgelagerten Bereich der ersten Prüfstelle liegt, und ferner einen Sektorisolationsparameter des Kabels zwischen der ersten und der zweiten Prüfstelle bestimmt, indem es den ersten Isolationsparameter vom zweiten Isolationsparameter subtrahiert.

14. System nach einem der Ansprüche 12 oder 13, ferner umfassend einen Isolationswandler zum Isolieren des elektrischen Systems gegenüber der Masse.

15. System nach einem der Ansprüche 12 bis 14, wobei:
das System ferner einen Signalgenerator (309) umfasst, der so konfiguriert ist, dass er die Wechselspannungsquelle (409, 410) und eine Vielzahl von Wechselstromsignalen bereitstellt, wobei der Signalgenerator (309) optional so konfiguriert ist, dass er ein Spreizspektrumsignal bereitstellt, das die Vielzahl von Wechselstromsignalen umfasst, und wobei der Signalprozessor optional ferner so konfiguriert ist, dass er die empfangenen gemessenen Frequenzgänge demoduliert und/oder
sich der Signalprozessor entfernt von der Wechselspannungsquelle (409, 410) befindet.

## Revendications

1. Procédé pour déterminer l'état d'un paramètre d'isolation de câble d'un câble (301) dans un système électrique, le procédé comprenant les étapes de :
fourniture (501), par une source de tension AC (409), d'une pluralité de signaux de courant alternatif entre un conducteur (401) du câble et une masse électrique (411), dans lequel la pluralité de signaux de courant alternatif comprennent une pluralité de fréquences, dans lequelles chaque signal de courant alternatif comprend une fréquence différente supérieure à zéro ;
mesure (501) d'une réponse en fréquence pour chacun de la pluralité de signaux de courant alternatif ;
détermination (502) d'une pluralité de déphasages, chacun de la pluralité de déphasages étant entre chaque signal de courant alternatif injecté et la réponse en fréquence mesurée correspondante, **caractérisé en ce que** :
chacun des déphasages est représenté en tant que vecteur phaseur (203) présentant une amplitude et un angle de phase et incluant une composante résistive et une composante capacitive, le procédé comprenant en outre l'étape de :
extrapolation (504) des vecteurs phaseurs (203) pour :
i) estimer le paramètre d'isolation de câble qui est un courant de fuite de résistance d'isolation correspondant à la composante résistive lorsque la composante capacitive est de zéro pour fournir une valeur de résistance d'isolation DC, ou
ii) estimer le paramètre d'isolation de câble qui est la capacité d'isolation en extrapolant la pluralité de déphasages jusqu'à un point qui est asymptotique et en déterminant la composante capacitive au niveau du point asymptotique.

2. Procédé selon la revendication précédente, dans lequel la fourniture des signaux de courant alternatif est mise en oeuvre tandis que le conducteur (401) est opérationnel.

3. Procédé selon l'une quelconque des revendications précédentes, dans lequel le système électrique est un système électrique non mis à la terre.

4. Procédé selon l'une quelconque des revendications précédentes, dans lequel la mesure de la réponse en fréquence est mise en oeuvre en utilisant un transformateur de courant (318) et facultativement, dans lequel le signal injecté est entre la fréquence de couplage minimum et la fréquence de saturation correspondant à la perméabilité électromagnétique du transformateur de courant (318).

5. Procédé selon l'une quelconque des revendications précédentes, dans lequel les étapes de fourniture et de mesure sont réalisées simultanément.

6. Procédé selon l'une quelconque des revendications précédentes, dans lequel le signal injecté et la réponse en fréquence mesurée sont échantillonnés numériquement.

7. Procédé selon l'une quelconque des revendications précédentes, dans lequel la pluralité de signaux de courant comprend au moins trois signaux de courant alternatif prédéfinis de fréquences différentes.

8. Procédé selon l'une quelconque des revendications précédentes, dans lequel le câble comprend au moins deux conducteurs (401, 402), et dans lequel les étapes de fourniture, de mesure, de détermination et d'extrapolation sont réalisées en relation avec un ou plusieurs des conducteurs (401, 402) .

9. Procédé selon l'une quelconque des revendications précédentes, dans lequel la masse électrique est la terre (411).

10. Procédé selon l'une quelconque des revendications précédentes, dans lequel le courant de fuite de résistance d'isolation est déterminé au niveau d'une pluralité de localisations de test distribuées le long du câble, le courant de fuite de résistance d'isolation au niveau de chacune de la pluralité de localisations de test étant le courant de fuite résistif total en aval du point de mesure respectif, et facultativement, comprenant en outre l'étape de détermination d'un premier paramètre au niveau d'une première localisation de test du câble et d'un second paramètre au niveau d'une seconde localisation de test du câble qui est en aval de la première localisation de test (403), dans lequel le paramètre du câble entre les première et seconde localisations de test (403, 404) est déterminé en soustrayant le second paramètre du premier paramètre.

11. Procédé selon l'une quelconque des revendications précédentes, dans lequel le câble est un câble de signalisation pour transmettre des signaux entre des composants d'un système de signalisation ferroviaire.

12. Système pour déterminer l'état d'un paramètre d'isolation de câble d'un système électrique, le système comprenant :
une source de tension AC (409, 410) configurée pour fournir une pluralité de signaux de courant alternatif entre un conducteur (401) du câble et une masse électrique (411), dans lequel la pluralité de signaux de courant alternatif comprennent une pluralité de fréquences, dans lequelles chaque signal de courant alternatif comprend une fréquence différente supérieure à zéro ;
un premier agencement de capteur (305) configuré pour mesurer une réponse en fréquence pour chacun de la pluralité de signaux de courant alternatif ; et
un processeur de signal configuré pour recevoir à la fois la pluralité de signaux de courant alternatif et une réponse en fréquence mesurée correspondante, et pour déterminer une pluralité de déphasages pour chaque signal de courant, **caractérisé en ce que** :
chacun des déphasages est représenté en tant que vecteur phaseur (203) présentant une amplitude et un angle de phase et incluant une composante résistive et une composante capacitive,
dans lequel le processeur de signal est en outre configuré pour extrapoler les vecteurs phaseurs (203) pour :
i) estimer le paramètre d'isolation de câble qui est un courant de fuite de résistance d'isolation correspondant à la composante résistive lorsque la composante capacitive est de zéro pour fournir une valeur de résistance d'isolation DC, ou
ii) estimer le paramètre d'isolation de câble qui est la capacité d'isolation en extrapolant la pluralité de déphasages jusqu'à un point qui est asymptotique et en déterminant la composante capacitive au niveau du point asymptotique.

13. Système selon la revendication 12, comprenant en outre une pluralité de points de mesure localisés le long du câble, chaque localisation de test étant configurée pour déterminer le courant de fuite de résistance d'isolation total en aval de la localisation de test respective, et le système étant facultativement configuré pour déterminer un premier paramètre d'isolation au niveau d'une première localisation de test et un second paramètre d'isolation au niveau d'une seconde localisation de test qui est en aval de la première localisation, et en outre déterminer un paramètre d'isolation de secteur du câble entre les première et seconde localisations de test en soustrayant le premier paramètre d'isolation du second paramètre d'isolation.

14. Système selon l'une quelconque des revendications 12 ou 13, comprenant en outre un transformateur d'isolation pour isoler le système électrique vis-à-vis de la masse.

15. Système selon l'une quelconque des revendications 12 à 14, dans lequel :
le système comprend en outre un générateur de signal (309) qui est configuré pour fournir la source de tension AC (409, 410) et une pluralité de signaux de courant alternatif, dans lequel le générateur de signal (309) est facultativement configuré pour fournir un signal à spectre étalé comprenant la pluralité de signaux de courant alternatif, et dans lequel le processeur de signal est en outre facultativement configuré pour démoduler les réponses en fréquence mesurées reçues et/ou
le processeur de signal est localisé à distance de la source de tension AC (409, 410).
